# EUROPEAN PATENT APPLICATION

(11) **EP 4 109 504 A1**
(43) Date of publication of application: **28.12.2022**
(21) Application number: 22164437.0
(22) Date of filing: 25.03.2022
(51) Int. Cl.: H01L 21/768

(54) **PROTECTIVE LAYER FOR GATE CAP REINFORCEMENT**

(30) Priority: 23.06.2021 US 202117356036
(71) Applicant: INTEL Corporation, Santa Clara, CA 95054 (US)
(72) Inventor: WALLACE, Charles H., Portland, OR 97212 (US); VYAS, Shashi, Euclid, OH 44123 (US); PANDIJA, Sachin, Hillsboro, OR 97124 (US); BOUCHE, Guillaume, Portland, OR 97211 (US); WEI, Andy Chih-Hung, Yamhill, OR 97148 (US)
(74) Representative: HGF

(57) **Abstract**

Embodiments described herein may be related to apparatuses, processes, and techniques related to protecting metal gates within transistor gate structures during SAC patterning. In particular, embodiments include area selective deposition techniques to deposit films on the gate or on a gate cap that have a good selectivity to SAC etch. In embodiments the film may include a combination of zirconium and/or oxygen, or may include zirconium oxide. Other embodiments may be described and/or claimed.

## Description

### FIELD

Embodiments of the present disclosure generally relate to the field of integrated circuit (IC) manufacturing, and in particular to gate structures.

### BACKGROUND

Continued growth in computing devices, virtual machines and cloud computing will continue to increase the demand for increased density and quality of transistors in an IC.

### BRIEF DESCRIPTION OF THE DRAWINGS

FIGs. 1A-1D illustrate stages in a legacy manufacturing process for self-aligned contact (SAC) patterning during manufacture of a transistor.
FIGs. 2A-2C illustrate stages in a manufacturing process for applying zirconium oxide to a gate cap, in accordance with various embodiments.
FIGs. 3A-3D illustrate stages in a manufacturing process for SAC patterning using zirconium oxide applied to the metal gates to protect the metal gates, in accordance with various embodiments.
FIGs. 4A-4G illustrate stages in a manufacturing process for depositing zirconium oxide onto a metal gate to protect the metal gates, in accordance with various embodiments.
FIGs. 5A-5F illustrate stages in a manufacturing process for depositing zirconium oxide on a silicon nitride surface, in accordance with various embodiments.
FIG. 6 illustrates an example process for SAC patterning using zirconium oxide to protect the metal gates during transistor manufacture, in accordance with various embodiments.
FIG. 7 illustrates a computing device 700 in accordance with one implementation of the invention.
FIG. 8 illustrates an interposer 800 that includes one or more embodiments of the invention.

### DETAILED DESCRIPTION

Embodiments described herein may be related to apparatuses, processes, and techniques to protect the metal gates, which may be also referred to as gates, within transistor gate structures during SAC patterning. In particular, embodiments may be directed to area selective deposition techniques to deposit films on the gate or on a gate that have a good selectivity to SAC etch. In embodiments the film may include a combination of zirconium and/or oxygen, or may include zirconium oxide. In embodiments, during the manufacture process, when zirconium oxide is deposited, the zirconium oxide will stay behind as a gate polish stop. In embodiments, a metal of the gate may include tungsten (W). In embodiments, in addition to zirconium oxide, other materials may be used, such as metal oxides that include aluminum oxide, hafnium oxide, titanium oxide, and the like.

In legacy implementations, gate metal recess and nitride capping techniques have been used to protect gates during SAC patterning. However, legacy etch selectivity to nitride caps during interlayer dielectric (ILD) etch results in corner erosion of the nitride and reducing the protection on the gate. An undesirable side effect of this legacy approach is that contact to gate electrical shorting may occur at that corner. Other legacy approaches have been to implement tall caps, such as nitride caps, on the gates to mitigate corner erosion. However, this technique may incur the cost of a high aspect ratio for the gate. The deeper gate recesses required using this technique increases variability. A taller aspect ratio at gate patterning needs to be accommodated, which may create more challenging process issues downstream such as line bending/collapse, incomplete silicon removal in a replacement metal gate process, incomplete nano-ribbon release in a gate all-around process (GAA), and the like.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

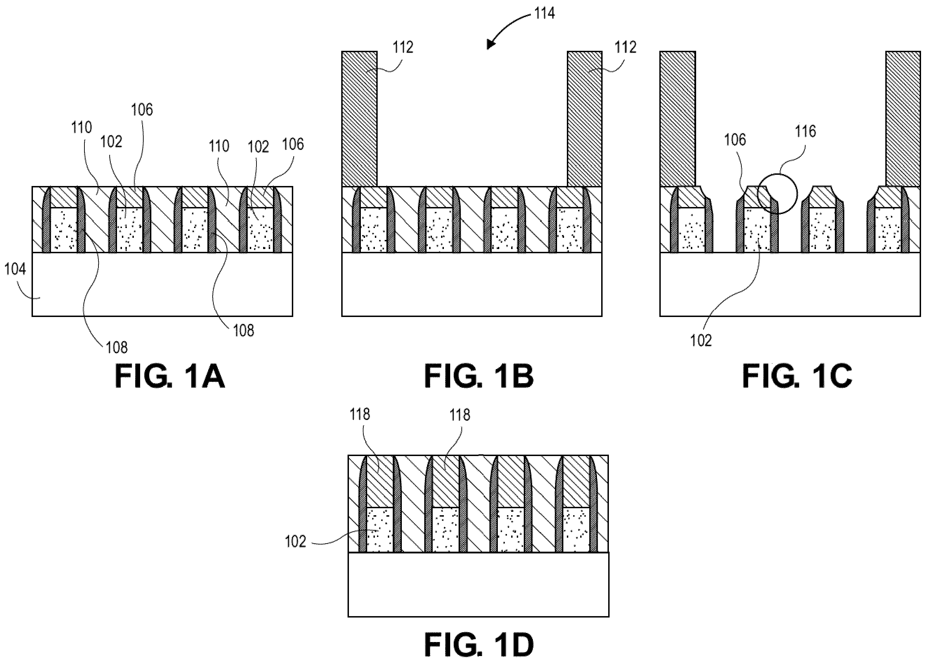

FIGs. 1A-1D illustrate stages in a legacy manufacturing process for self-aligned contact (SAC) patterning during manufacture of a transistor. FIG. 1A shows a cross-section of a portion of a transistor under manufacture, that includes a plurality of metal gates 102 coupled with a FinFET 104, which includes a source/drain epitaxy. The metal gates 102 included dielectric (for instance silicon nitride) cap 106 on top of the surface of the metal gates 102. At the side of the metal gates 102 and the dielectric cap 106 is a gate spacer 108. The gates are separated by a dielectric 110, which may be a silicon oxide dielectric that fills the trenches between the metal gates 102.

In embodiments, the gate pitch between the metal gates 102 may be on the order of 50 nm. Thus, the separation (or the hole) between the metal gates 102 represented by the dielectric 110 may be on the order of 20 nm. Instead of drilling out holes between the metal gates 102, an etch process may be used to selectively remove the dielectric 110.

FIG. 1B shows the structure of FIG. 1A, with photoresist 112 added to create a SAC pattern opening 114. FIG. 1C shows the structure of FIG. 1B where a reactive ion etch has been applied to etch away the dielectric 110. However, the reactive ion etch is not perfectly selective and typically not only removes the dielectric 110, but also removes a portion of the dielectric cap 106, which reduces the protection at the corner of the metal gates 102, and therefore increases the likelihood of a short between the metal gates 102 and an adjacent contact (not shown) in the area 116.

FIG. 1D shows an alternate legacy approach of FIG. 1A, where taller caps 118 are put above the metal gates 102, so that the reactive ion at does not etch away the taller cap 118 as much and therefore leaves more margin with the metal gates 102, decreasing the likelihood of a short between the metal gates 102 and an adjacent contact (not shown). However, a taller cap 118 means a taller aspect ratio for gates, which makes patterning more difficult. In addition, there is a performance issue with having a taller cap 118 between the gate and the contact (not shown). The taller the lateral overlap between the taller cap 118 and the adjacent contacts, the higher the front-end parasitic capacitance. This approach may have a negative effect on device performance and the ability of the device to perform at higher frequencies. Also individual devices performances may vary due to variation of final gate height over the diffusion, for example FinFET or nanoribbon/nanosheet/nanowire, caused by metal gate recess depth variability, forcing designers to guard against those variations.

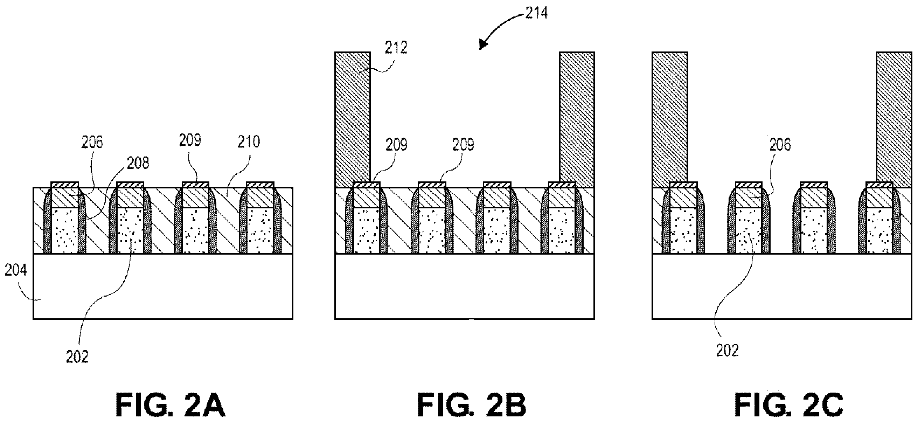

FIGs. 2A-2C illustrate stages in a manufacturing process for applying zirconium oxide to a gate cap, in accordance with various embodiments. FIGs. 2A-2C may be similar to FIGs. 1A-1C. Metal gates 202, FinFET 204, gate spacer 208, gate cap 206, and dielectric 210 may be similar to metal gates 102, FinFET 104, gate spacer 108, gate cap 106, and dielectric 110 of FIGs. 1A-1C.

FIG. 2A shows a zirconium oxide film 209 that is deposited on the gate cap 206. The zirconium oxide film 209 serves as a protective barrier to prevent the reactive ion etch process as shown with respect to FIG. 2C, after the photoresist 212 of FIG. 2B, which may be similar to photoresist 112 of FIG. 1B, is applied in area 214, from etching away any margin within the gate cap 206. Thus protecting the metal gates 202 from any inadvertent unwanted electrical contact. In embodiments, a portion of the deposited zirconium oxide 209 may be subsequently polished away. In embodiments, after the trench contacts are formed and filled with metal, the chemical mechanical polish (CMP) process removes excess metal and also can be used to remove the metal oxide cap that was deposited. It may be desired in some embodiments to leave the metal oxide cap intact in order to provide an etch stop for VIA processing. The vias that land on the trench contacts can short to gates. Leaving the metal oxide intact can prevent this shorting.

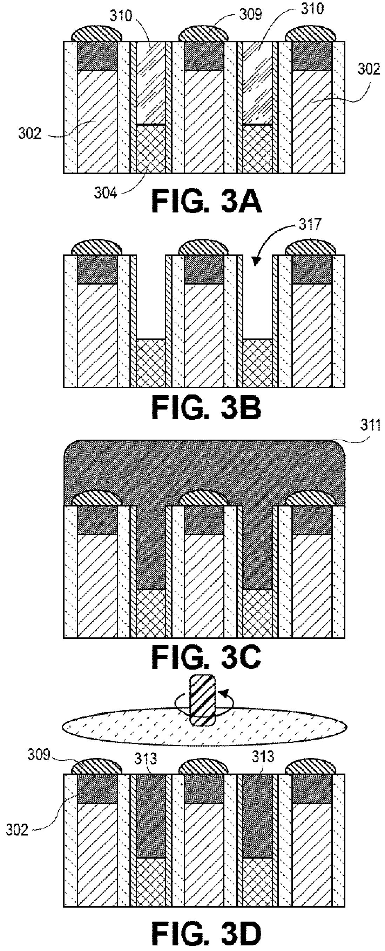

FIGs. 3A-3D illustrate stages in a manufacturing process for SAC patterning using zirconium oxide applied to the metal gates to protect the metal gates, in accordance with various embodiments. Note that is described herein, reference may be made to a transistor that includes a FinFET implementation. Embodiments may also apply to a transistor that includes gate all around (GAA) implementation.

FIG. 3A may be similar to FIG. 1A. FIG. 3A shows multiple gates 302 on to which a layer of zirconium oxide 309 has been deposited. In embodiments, the entire surface of gates 302 may be covered with the layer of zirconium oxide 309. In embodiments, portions of a FinFET 304 - or extension of FinFet 304 by means of a raised epitaxial source drain vertical extension - will be positioned between the gates 302, and have a silicon oxide 310 above the FinFET 304 and between the sides of the gates 302.

At FIG. 3B, a selective etch is performed to remove the silicon oxide 310 to create a cavity 317, in preparation for a metal deposit, which may include a photoresist, such as photoresist 112 of FIG. 1B, that is not shown with respect to FIG. 3B.

At FIG. 3C, metal 311 is deposited to form various trench connectors where the silicon oxide 310 used to be. In embodiments, the metal 311 that is deposited may include tungsten (W), or any other metal that may be used to form a trench connector and/or a gate. In embodiments, other metals may include, for example, titanium, titanium nitride, cobalt, ruthenium, molybdenum, or a combination of these.

At FIG. 3D, the metal 311 is polished to bring the trench connectors 313 in line with the top of the gates 302. In embodiments, the polish may be a polish for tungsten, where the zirconium oxide layer 309 serves as a stop layer for the polish. As a result, in embodiments, at least part of zirconium oxide layer 309 will remain on the surface of the gate 302.

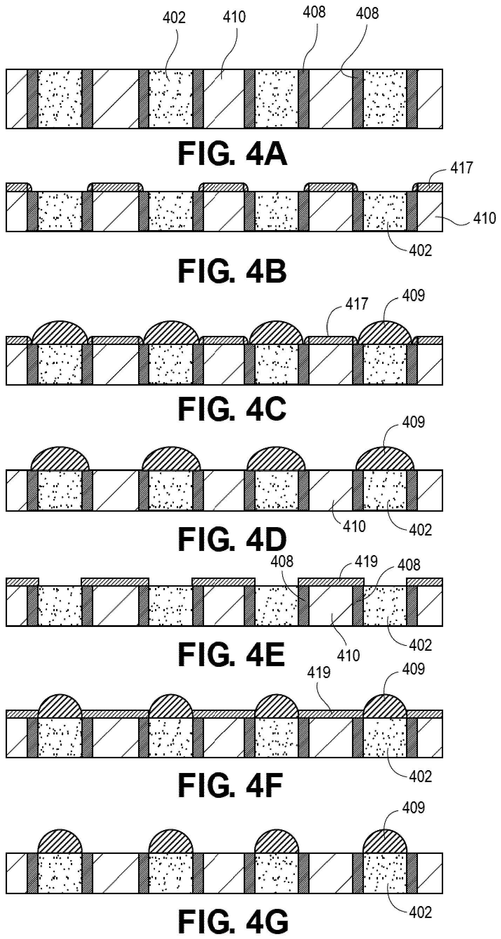

FIGs. 4A-4G illustrate stages in a manufacturing process for depositing zirconium oxide onto a metal gate to protect the metal gates, in accordance with various embodiments. FIG. 4A shows an initial series of metal gates 402, for instance tungsten gates, which may be similar to metal gates 102 of FIG. 1A. The series includes gate spacer 408, which may be similar to gate spacer 108 of FIG. 1A, that may be immediately surrounding the metal gates 402, and include Silicon Oxy-Carbide (SiOC) or a variation of SiOC, for example, with nitrogen or boron incorporated. It can also be made of silicon nitride SiN. The metal gates 402 may be separated by a dielectric 410, that may be similar to dielectric 110 of FIG. 1A. The dielectric 410 may include silicon oxide.

FIG. 4B is the first stage of a first case of a passivation layer 417 applied to FIG. 4A. In embodiments, a silane based self-assembly monolayer (SAM) passivant layer 417 is applied to all surfaces and attaches itself only to the dielectric 410. In embodiments the SAM passivant layer 417 may be multiple layers. This leaves the surface of the metal gates 402 available to receive the deposited or grown metal, for example tungsten (W), as discussed with respect to FIG. 4C.

FIG. 4C shows selective zirconium oxide growth on the metal gates 402. In embodiments, the passivant layer 417 may allow some zirconium oxide growth on the gate spacer 408.

FIG. 4D shows the passivant layer 417 removed, exposing the zirconium oxide layer 409 that is covering and protecting the metal gates 402.

FIG. 4E is the first stage of a second case of a passivation layer 419 that may include a selective carbon passivant that grows on both the gate spacer 408 and the dielectric 410.

FIG. 4F shows selective growth of zirconium oxide 409 on the metal gates 402.

FIG. 4G shows the removal of the passivant layer 419.

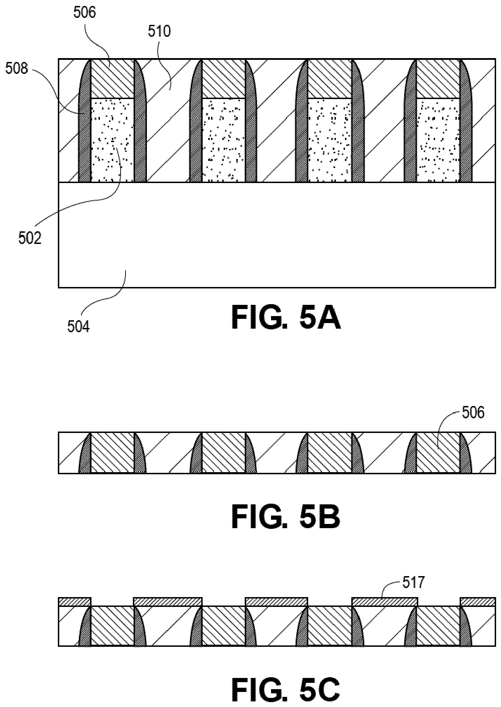

FIGs. 5A-5F illustrate stages in a manufacturing process for depositing zirconium oxide on a silicon nitride surface, in accordance with various embodiments. The processes described herein may use silane-based chemistries to block SiO2 surfaces by bonding with -OH groups on the SiO2 surface. In embodiments, the SiN surface is pre-cleaned to get the native SiOx removed so that the passivant can go only on the SiOx and not SiN.

FIG. 5A shows an initial series of tungsten gates 502, which may be similar to metal gates 102 of FIG. 1A. The gates 502 may be coupled with a FinFET 504, which may be similar to FinFET 104 of FIG. 1A. The series may include gate spacers 508, which may be similar to gate spacer 108 of FIG. 1A, and may immediately surround the gate 502. In embodiments, the gate spacers 508 may include SiOC. The gates 502 may be separated by a dielectric 510, that may be similar to dielectric 110 of FIG. 1A. The dielectric 510 may include silicon oxide. In addition, the gates 502 may have a gate cap 506, that may be similar to gate cap 106 of FIG. 1A. The gate cap 506 may include SiN.

FIG. 5B shows a detail of a top portion of FIG. 5A, wherein the gate cap 506 may have a native surface oxide layer on top of the gate cap 506. In embodiments, this native surface oxide layer may be less than 1 nm in thickness. FIG. 5B, the surface oxide layer has been removed.

FIG. 5C shows a selective passivation layer 517 applied to the surface, where the passivation layer adheres only to the silicon oxide dielectric 510 and the gate spacer 508. In embodiments, the passivation layer 517 may be approximately 2 nm thick. In embodiments, a thickness may range from 2 nm to 10 nm

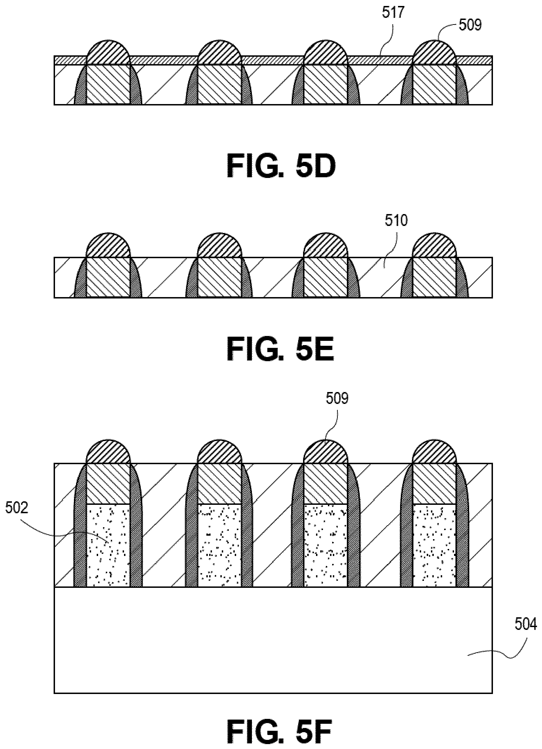

FIG. 5D shows a deposit of zirconium oxide 509 on top of the gate 502. In embodiments, the deposition of the zirconium oxide 509 may be performed through an area selective deposit (ASD) process. In embodiments, the zirconium oxide layer 509 may be between 3 nm and 5 nm in thickness.

FIG. 5E shows the passivant layer 517 removed, exposing the silicon oxide dielectric 510.

FIG. 5F shows an enlarged view of the gates 502 on FinFET 504 after the zirconium oxide 509 deposit.

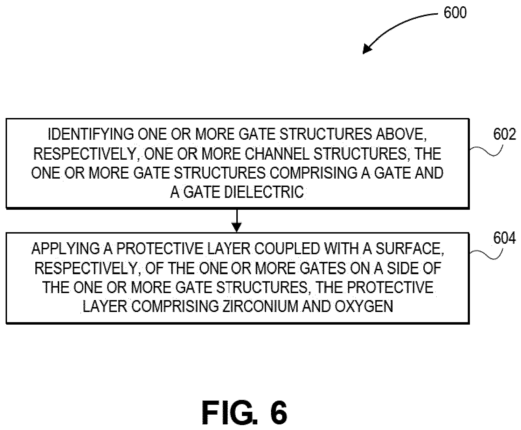

FIG. 6 illustrates an example process for SAC patterning using zirconium oxide to protect the metal gates during transistor manufacture, in accordance with various embodiments. Process 600 may be implemented with any of the techniques, processes, systems, or methods described herein, and in particular with respect to FIGs. 2A-5E.

At block 602, the process may include identifying one or more gate structures above, respectively, one or more channel structures, the one or more gate structures comprising a gate and a gate dielectric.

At block 604, the process may further include applying a protective layer coupled with a surface, respectively, of the one or more gates on a side of the one or more gate structures, the protective layer comprising zirconium and oxygen.

Implementations of embodiments of the invention may be formed or carried out on a substrate, such as a semiconductor substrate. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V or group IV materials. Although a few examples of materials from which the substrate may be formed are described here, any material that may serve as a foundation upon which a semiconductor device may be built falls within the spirit and scope of the present invention.

A plurality of transistors, such as metal-oxide-semiconductor field-effect transistors (MOSFET or simply MOS transistors), may be fabricated on the substrate. In various implementations of the invention, the MOS transistors may be planar transistors, nonplanar transistors, or a combination of both. Nonplanar transistors include FinFET transistors such as double-gate transistors and tri-gate transistors, and wrap-around or all-around gate transistors such as nanoribbon and nanowire transistors. Although the implementations described herein may illustrate only planar transistors, it should be noted that the invention may also be carried out using nonplanar transistors.

Each MOS transistor includes a gate stack formed of at least two layers, a gate dielectric layer and a gate electrode layer. The gate dielectric layer may include one layer or a stack of layers. The one or more layers may include silicon oxide, silicon dioxide (SiO2) and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The gate electrode layer is formed on the gate dielectric layer and may consist of at least one P-type workfunction metal or N-type workfunction metal, depending on whether the transistor is to be a PMOS or an NMOS transistor. In some implementations, the gate electrode layer may consist of a stack of two or more metal layers, where one or more metal layers are workfunction metal layers and at least one metal layer is a fill metal layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of an NMOS gate electrode with a workfunction that is between about 3.9 eV and about 4.2 eV.

In some implementations, the gate electrode may consist of a "U"-shaped structure that includes a bottom portion substantially parallel to the surface of the substrate and two sidewall portions that are substantially perpendicular to the top surface of the substrate. In another implementation, at least one of the metal layers that form the gate electrode may simply be a planar layer that is substantially parallel to the top surface of the substrate and does not include sidewall portions substantially perpendicular to the top surface of the substrate. In further implementations of the invention, the gate electrode may consist of a combination of U-shaped structures and planar, non-U-shaped structures. For example, the gate electrode may consist of one or more U-shaped metal layers formed atop one or more planar, non-U-shaped layers.

In some implementations of the invention, a pair of sidewall spacers may be formed on opposing sides of the gate stack that bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In an alternate implementation, a plurality of spacer pairs may be used, for instance, two pairs, three pairs, or four pairs of sidewall spacers may be formed on opposing sides of the gate stack.

As is well known in the art, source and drain regions are formed within the substrate adjacent to the gate stack of each MOS transistor. The source and drain regions are generally formed using either an implantation/diffusion process or an etching/deposition process. In the former process, dopants such as boron, aluminum, antimony, phosphorous, or arsenic may be ion-implanted into the substrate to form the source and drain regions. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate the source and drain regions. In some implementations, the source and drain regions may be fabricated using a silicon alloy such as silicon germanium or silicon carbide. In some implementations the epitaxially deposited silicon alloy may be doped in situ with dopants such as boron, arsenic, or phosphorous. In further embodiments, the source and drain regions may be formed using one or more alternate semiconductor materials such as germanium or a group III-V material or alloy. In further embodiments, one or more layers of metal and/or metal alloys may be used to form the source and drain regions.

One or more interlayer dielectrics (ILD) are deposited over the MOS transistors. The ILD layers may be formed using dielectric materials known for their applicability in integrated circuit structures, such as low-k dielectric materials. Examples of dielectric materials that may be used include, but are not limited to, silicon dioxide (SiO₂), carbon doped oxide (CDO), silicon nitride, organic polymers such as perfluorocyclobutane or polytetrafluoroethylene, fluorosilicate glass (FSG), and organosilicates such as silsesquioxane, siloxane, or organosilicate glass. The ILD layers may include pores or air gaps to further reduce their dielectric constant.

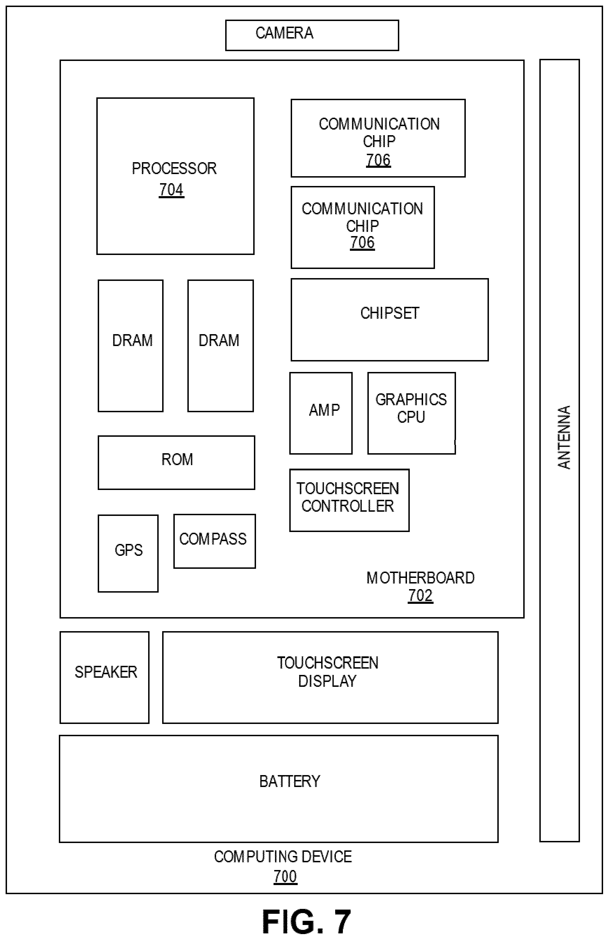

FIG. 7 illustrates a computing device 700 in accordance with one implementation of the invention. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

Depending on its applications, computing device 700 may include other components that may or may not be physically and electrically coupled to the board 702. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In some implementations of the invention, the integrated circuit die of the processor includes one or more devices, such as MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 706 also includes an integrated circuit die packaged within the communication chip 706. In accordance with another implementation of the invention, the integrated circuit die of the communication chip includes one or more devices, such as MOS-FET transistors built in accordance with implementations of the invention.

In further implementations, another component housed within the computing device 700 may contain an integrated circuit die that includes one or more devices, such as MOS-FET transistors built in accordance with implementations of the invention.

In various implementations, the computing device 700 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 700 may be any other electronic device that processes data.

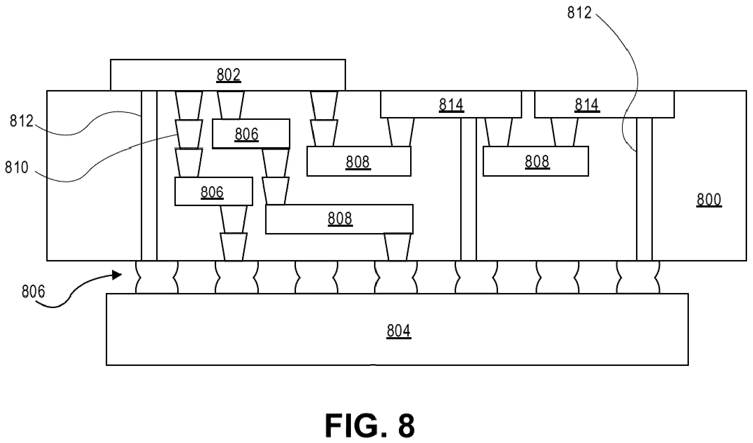

FIG. 8 illustrates an interposer 800 that includes one or more embodiments of the invention. The interposer 800 is an intervening substrate used to bridge a first substrate 802 to a second substrate 808. The first substrate 802 may be, for instance, an integrated circuit die. The second substrate 804 may be, for instance, a memory module, a computer motherboard, or another integrated circuit die. Generally, the purpose of an interposer 800 is to spread a connection to a wider pitch or to reroute a connection to a different connection. For example, an interposer 800 may couple an integrated circuit die to a ball grid array (BGA) 806 that can subsequently be coupled to the second substrate 804. In some embodiments, the first and second substrates 802/804 are attached to opposing sides of the interposer 800. In other embodiments, the first and second substrates 802/804 are attached to the same side of the interposer 800. And in further embodiments, three or more substrates are interconnected by way of the interposer 800.

The interposer 800 may be formed of an epoxy resin, a fiberglass-reinforced epoxy resin, a ceramic material, or a polymer material such as polyimide. In further implementations, the interposer may be formed of alternate rigid or flexible materials that may include the same materials described above for use in a semiconductor substrate, such as silicon, germanium, and other group III-V and group IV materials.

The interposer 800 may include metal interconnects 808 and vias 810, including but not limited to through-silicon vias (TSVs) 812. The interposer 800 may further include embedded devices 814, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 800. In accordance with embodiments of the invention, apparatuses or processes disclosed herein may be used in the fabrication of interposer 800.

The above description of illustrated embodiments, including what is described in the Abstract, is not intended to be exhaustive or to limit embodiments to the precise forms disclosed. While specific embodiments are described herein for illustrative purposes, various equivalent modifications are possible within the scope of the embodiments, as those skilled in the relevant art will recognize.

These modifications may be made to the embodiments in light of the above detailed description. The terms used in the following claims should not be construed to limit the embodiments to the specific implementations disclosed in the specification and the claims. Rather, the scope of the invention is to be determined entirely by the following claims, which are to be construed in accordance with established doctrines of claim interpretation.

The following paragraphs describe examples of various embodiments, which may be combined in any reasonable combination to result in further example embodiments.

### EXAMPLES

Example 1 is an integrated circuit comprising: one or more gate structures above, respectively, one or more channel structures, the one or more gate structures comprising a gate and a dielectric isolation area between the metal gates; and a protective layer coupled with a surface, respectively, of the one or more gates on a side of the one or more gate structures, the protective layer comprising a metal oxide.

Example 2 includes the integrated circuit of example 1, wherein the protective layer comprising the metal oxide includes zirconium and oxygen.

Example 3 includes the integrated circuit of example 1, wherein the protective layer completely covers each surface of the one or more gates.

Example 4 includes the integrated circuit of example 1, wherein the protective layer has a first side and a second side opposite the first side, wherein the first side of the protective layer is in physical contact only with the surface of the one or more gates.

Example 5 includes the integrated circuit of example 1, wherein the gate further includes a gate spacer surrounding the gate and between the gate and the adjacent contact area dielectric.

Example 6 includes the integrated circuit of example 5, wherein the gate spacer is a silicon nitride (SiN), and the dielectric material is a silicon oxide (SiO₂).

Example 7 includes the integrated circuit of example 5, further including a passivation layer on the side of the one or more gate structures, the passivation layer coupled with a surface of the side of the one or more gate structures that is not covered by the protective layer.

Example 8 includes the integrated circuit of example 7, wherein the passivation layer is a selected one of: a Silane SAMs passivant or a carbon passivant.

Example 9 includes the integrated circuit of any one of examples 1-8, wherein the gate includes tungsten (W) or a tungsten alloy.

Example 10 is a method comprising: providing one or more gate structures above, respectively, one or more channel structures, the one or more gate structures comprising a gate and a dielectric isolation between the gates; and applying a protective layer coupled with a surface, respectively, of the one or more gates on a side of the one or more gate structures, the protective layer comprising a metal oxide.

Example 11 includes the method of example 10, wherein the protective layer includes zirconium oxide.

Example 12 includes the method of example 10, wherein applying the protective layer further includes depositing zirconium and oxygen.

Example 13 includes the method of example 10, wherein applying the protective layer further includes applying a passivation layer to the side of the one or more gate structures that does not include the surfaces of the one or more gates, wherein the passivation layer exposes the surfaces of the one or more gates.

Example 14 includes the method of example 13, wherein applying the protective layer further includes selectively growing zirconium oxide on the exposed surfaces of the one or more gates.

Example 15 includes the method of any one of examples 10-14, wherein the passivation layer includes a selected one or more of: a silane self-assembly monolayer (SAM) or selective carbon.

Example 16 is an integrated circuit comprising: a transistor; one or more channel structures coupled with the transistor; one or more gate structures coupled, respectively, with the one or more channel structures, the one or more gate structures comprising a gate and a gate dielectric; and a protective layer coupled with a surface, respectively, of the one or more gates on a side of the one or more gate structures, the protective layer comprising a metal oxide.

Example 17 includes the integrated circuit of example 16, wherein the transistor includes a selected one of: a FinFET or a Gate All Around (GAA) device.

Example 18 includes the integrated circuit of example 16, wherein the protective layer completely covers each surface of the one or more gates.

Example 19 includes the integrated circuit of any one of example 16-18, wherein the gate further includes a gate spacer surrounding the gate and between the gate and the contact area dielectric.

Example 20 includes the integrated circuit of example 19, wherein the gate spacer is a silicon nitride (SiN) or an SiOCN, and the dielectric material is a silicon oxide (SiO₂).

## Claims

1. An integrated circuit comprising:
one or more gate structures above, respectively, one or more channel structures, the one or more gate structures comprising a gate and a gate dielectric; and
a protective layer coupled with a surface, respectively, of the one or more gates on a side of the one or more gate structures, the protective layer comprising zirconium and oxygen.

2. The integrated circuit of claim 1, wherein the protective layer comprising zirconium and oxygen includes zirconium oxide.

3. The integrated circuit of claim 1 or 2, wherein the protective layer completely covers each surface of the one or more gates.

4. The integrated circuit of any of claims 1 to 3, wherein the protective layer has a first side and a second side opposite the first side, wherein the first side of the protective layer is in physical contact only with the surface of the one or more gates.

5. The integrated circuit of any of claims 1 to 4, wherein the gate further includes a gate spacer surrounding the gate and between the gate and the gate dielectric.

6. The integrated circuit of claim 5, wherein the gate spacer is a silicon nitride (SiN), and the dielectric material is a silicon oxide (SiO₂).

7. The apparatus of claim 5 or 6, further including a passivation layer on the side of the one or more gate structures, the passivation layer coupled with a surface of the side of the one or more gate structures that is not covered by the protective layer.

8. The apparatus of claim 7, wherein the passivation layer is a selected one of: a Silane SAMs passivant or a carbon passivant.

9. The apparatus of any of claims 1 to 8, wherein the gate includes tungsten (W) or a tungsten alloy.

10. A method comprising:
providing one or more gate structures above, respectively, one or more channel structures, the one or more gate structures comprising a gate and a gate dielectric; and
applying a protective layer coupled with a surface, respectively, of the one or more gates on a side of the one or more gate structures, the protective layer comprising zirconium and oxygen.

11. The method of claim 10, wherein the protective layer is zirconium oxide.

12. The method of claim 10 or 11, wherein applying the protective layer further includes depositing zirconium and oxygen.

13. The method of any of claims 10 to 12, wherein applying the protective layer further includes applying a passivation layer to the side of the one or more gate structures that does not include the surfaces of the one or more gates, wherein the passivation layer exposes the surfaces of the one or more gates.

14. The method of claim 13, wherein applying the protective layer further includes selectively growing zirconium oxide on the exposed surfaces of the one or more gates.

15. The method of any of claims 10 to 14, wherein the passivation layer includes a selected one or more of: a slilane SAM or selective carbon.
